# EUROPEAN PATENT APPLICATION

(11) **EP 2 720 048 A2**
(43) Date of publication of application: **16.04.2014**
(21) Application number: 13187937.1
(22) Date of filing: 09.10.2013
(51) Int. Cl.: G01R 13/02, G06F 17/15

(54) **Multi-signal covariance and correlation processing on a test and measurement instrument**

(30) Priority: 09.10.2012 US 201213647939
(71) Applicant: TEKTRONIX, INC., Beaverton, OR 97077-0001 (US)
(72) Inventor: Hiltner, David, Beaverton, OR Oregon 97006 (US)
(74) Representative: Clarke, Jeffrey

(57) **Abstract**

Methods and instruments for generating covariance and correlation values of two or more signals. The covariance or correlation values (150) are used to compare intervals of interest of the two signals and to produce trigger events based on similarities between the two signals. A reference signal is digitized and stored, and then used as a reference when comparing to a real-time input signal (140). Mean values of the input signal and the previously stored reference signal are generated so that suitable covariance and correlation values can be generated. Threshold detectors detect when the covariance value and/or the correlation value exceed certain thresholds, which can cause the test and measurement instrument (105) to be triggered.

## Description

### BACKGROUND

Embodiments of the present invention relate to correlating multiple signals, and more particularly, to processing covariance and correlation measurements of two or more signals on a test and measurement instrument.

Modern test and measurement instruments, such as high-speed digital oscilloscopes, include acquisition systems that capture measurement data pertaining to incoming electrical signals under test. Different kinds of criteria can be used to trigger an acquisition of data on the test and measurement instrument. For example, triggering can be based on a similarity of an input signal to a digitally stored pattern. The similarity can be related to an edge, slew rates, aberrations, discontinuities, or the like. By way of another example, triggering criteria may require that a signal has met previously set standards for a particular wave shape.

Current methods for comparing data to fixed limits can create a number of "gates" where the signal must be between the sides of the gate at the times indicated. Generally, this requires digitization of the signal to compare with the gates. In addition, one must know timing from the clock edge to the "gate" to make accurate determinations.

Moreover, one of the more difficult problems with digital circuits relates to clock sources in asynchronous systems. When two or more clock sources happen to simultaneously change states at the same time, setup and hold time violations are inevitable and many digital circuits will exhibit metastability, and as a result, may generate radically incorrect results due to bits being settled to values that do not correlate well with other bits because of minor differences in propagation delay. Such problems are difficult to troubleshoot because, in general, there are no conventional means of only triggering when two clocks are transitioning together.

Alternative approaches for correlating two different signals may use laser image comparison, or digital signal processing (DSP) variations, but are inherently constrained by the speed of the algorithms used for the implementation, and the available clock rates. Such limitations in the prior art prevent a system from operating at higher frequencies in which a finer resolution around particular intervals of the signal would be desirable.

Accordingly, a need remains for a hybrid analog/digital covariance and correlation engine suitable for operation at high frequency and finer resolutions, where the standard digital techniques are prohibitively difficult or impossible. In addition, it would be desirable to provide an apparatus and method for processing one fixed and one time-variant input, allowing comparison against a predetermined value. In addition, it would be desirable to provide an apparatus and method for triggering only when two clocks are transitioning together. Embodiments of the invention address these and other limitations in the prior art.

### BRIEF DESCRIPTION OF THE DRAWINGS

Figure 1 illustrates an example test and measurement instrument including covariance-correlation logic in accordance with embodiments of the present invention.

Figures 2A-2D illustrate high-level block diagrams of the covariance-correlation logic of Figure 1.

Figure 3 illustrates an example circuit diagram of the covariance-correlation logic of Figure 2A.

Figure 4 illustrates an example circuit diagram of the covariance-correlation logic of Figure 2B.

Figure 5 illustrates another example circuit diagram of the covariance-correlation logic of Figure 2B.

Figure 6 illustrates an example circuit diagram of the covariance-correlation logic of Figure 2C.

Figure 7 illustrates an example circuit diagram of the covariance-correlation logic of Figure 2D.

Figure 8 illustrates an example cross-talk detector instrument including covariance-correlation logic in accordance with embodiments of the present invention.

The foregoing and other features and advantages of the inventive concepts will become more readily apparent from the following detailed description of the example embodiments, which proceeds with reference to the accompanying drawings.

### DETAILED DESCRIPTION

Reference will now be made in detail to embodiments of the present invention, examples of which are illustrated in the accompanying drawings. In the following detailed description, numerous specific details are set forth to enable a thorough understanding of the inventive concepts. It should be understood, however, that persons having ordinary skill in the art may practice the inventive concepts without these specific details. In other instances, well-known methods, procedures, components, circuits, and networks have not been described in detail so as not to unnecessarily obscure aspects of the embodiments.

It will be understood that, although the terms first, second, etc. may be used herein to describe various elements, these elements should not be limited by these terms. These terms are only used to distinguish one element from another. For example, a first circuit could be termed a second circuit, and, similarly, a second circuit could be termed a first circuit, without departing from the scope of the inventive concept.

The terminology used in the description of the various embodiments herein is for the purpose of describing particular embodiments only and is not intended to be limiting of the inventive concepts. As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The components and features of the drawings are not necessarily drawn to scale.

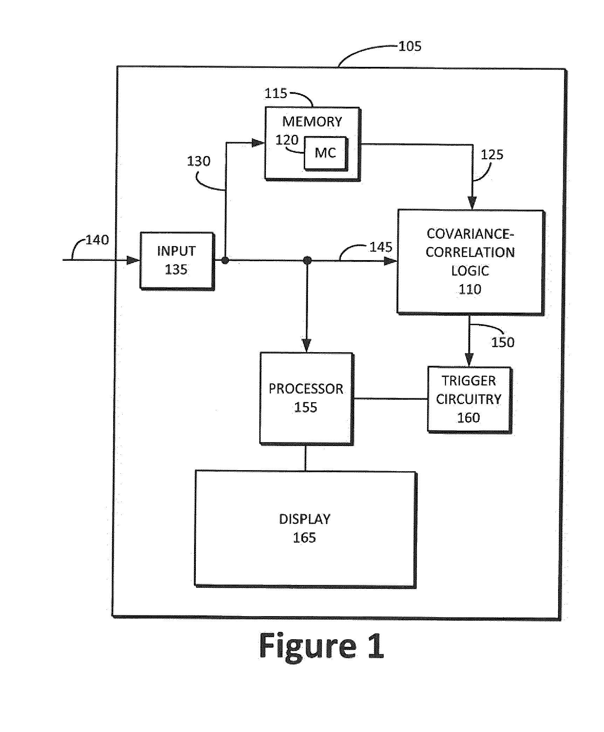

Figure 1 illustrates an example test and measurement instrument 105 including covariance-correlation logic 110 in accordance with embodiments of the present invention. The test and measurement instrument 105 can be an oscilloscope, a cross-talk detector, a logic analyzer, a spectrum analyzer, a network analyzer, or the like. Generally, for the sake of consistency and explanation, the test and measurement instrument 105 is referred to herein as an oscilloscope.

The oscilloscope 105 can include an input section 135, which receives an input electrical signal under test 140. The input section 135 can include acquisition circuitry, amplifiers, converters, or the like, and can be connected to a memory 115 via line 130. The memory 115 can store one or more acquisition records related to the input signal 140. The memory 115 can include a memory controller 120, which controls the writing and reading of digitized data to and from the memory 115. The memory 115 can be dynamic memory, static memory, read-only memory, random-access memory, or any other suitable variety of memory. The memory 115 can store a digital representation of a reference signal or other pre-recorded digitized data for later comparison with another input signal, as further described below.

The input section 135 may also be coupled to covariance-correlation logic 110 via line 145 so that the covariance-correlation logic 110 can receive the input signal 140. The covariance-correlation logic 110 may also receive digitized data pertaining to a pre-recorded digital representation of a reference signal from the memory 115 via line 125. The term "covariance-correlation logic" refers to analog circuits, digital circuits, hardware circuits, firmware, and/or software, or any suitable combination thereof, for producing covariance and/or correlation values related to two or more signals. Example embodiments of the covariance-correlation logic 110 are described below.

The covariance-correlation logic 110 may be coupled to trigger circuitry 160, which may trigger the oscilloscope 105 based on criteria determined at least in part by the covariance-correlation logic 110. A processor 155 may be coupled to the trigger circuitry 160 and a display 165. The processor 155 may coordinate the processing of data between the input 135, the covariance-correlation logic 110, and the trigger circuitry 160, and may cause trigger information, waveform information, and/or other measurement information to be displayed on the display 165.

The covariance-correlation logic 110 can compare the input signal 140 to previously recorded digitized information 125 to determine whether the input signal 140, or portions thereof, match previously set criteria for wave shape related to the prerecorded digitized information 125. The trigger circuitry 160 can trigger the oscilloscope 105 if there is a match, or in other words, if the wave shape criteria or other predefined criteria are otherwise satisfied. In other words, the covariance-correlation logic 110 can facilitate a "looks like this" trigger, in which the trigger circuitry 160 triggers the oscilloscope 105 if one or more portions of the input signal 140 looks like, or is otherwise sufficiently similar to, one or more portions of a previously recorded reference signal represented by digital data 125. The embodiments described herein are primarily concerned with systems having one fixed and one time variant input, allowing comparison against predetermined values. The covariance-correlation logic 110 can transmit one or more signals 150 to the trigger circuitry 160 when covariance and/or correlation values exceed certain thresholds, as further described below.

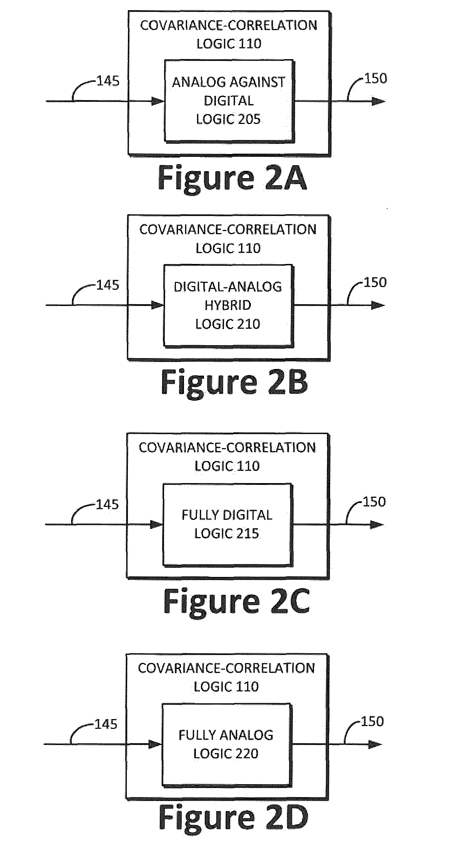

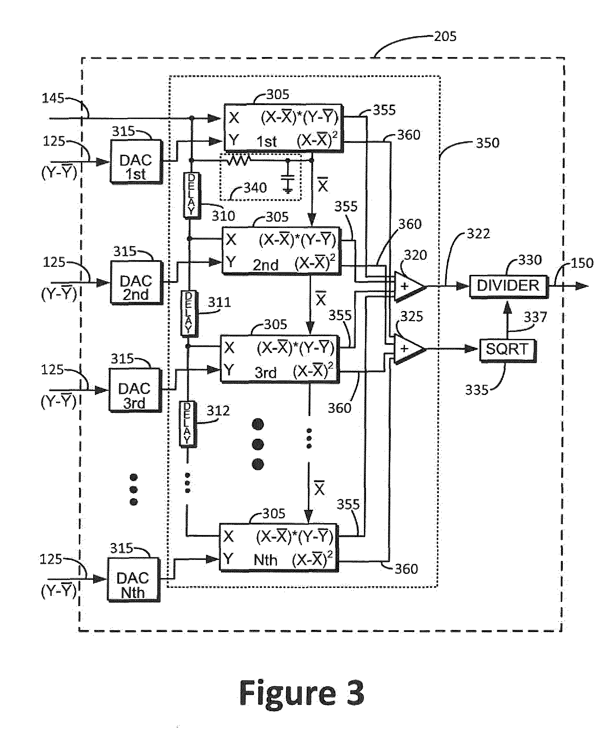

Figure 2A illustrates an example high-level block diagram of the covariance-correlation logic 110 of Figure 1, including analog against digital logic 205. Figure 2B illustrates another example high-level block diagram of the covariance-correlation logic 110 of Figure 1, including digital-analog hybrid logic 210. Figure 2C illustrates yet another example high-level block diagram of the covariance-correlation logic 110 of Figure 1, including fully digital logic 215. Figure 2D illustrates still another example high-level block diagram of the covariance-correlation logic 110 of Figure 1, including fully analog logic 220. Each of these example embodiments are described in further detail below with reference to Figures 3-7.

Figure 3 illustrates an example circuit diagram of the analog against digital logic 205 of the covariance-correlation logic 110 of Figure 2A. The analog against digital logic 205 includes 1^{st} through Nth digital to analog converters (DACs) 315. Each DAC 315 receives one or more portions of a previously digitized and recorded reference signal 125 from the memory 115 (of Figure 1), and converts the one or more portions to analog representations of the reference signal Y. 1^{st} through Nth multiply and square circuits 305 receive the analog representations from the 1^{st} through Nth DACs 315, respectively.

The 1^{st} multiply and square circuit 305 receives a real-time analog input signal 145, also referred to herein as X, which is generally the electrical signal under test received by the oscilloscope 105. The input signal 145 is delayed by a delay line 310. The 2^{nd} multiply and square circuit 305 receives the signal 145 delayed by delay line 310. The input signal is further delayed by delay line 311. The 3^{rd} multiply and square circuit 305 receives the signal 145 delayed by delay lines 310 and 311. The input signal 145 is further delayed by delay line 312, and so forth, until the Nth multiply and square circuit 305 receives the input signal 145 delayed by all of the intervening delay lines.

An RC circuit 340 receives the input signal 145 and produces a mean, or low pass filtered, signal Xbar. The mean value Xbar is passed from the 1^{st} multiply and square circuit 305 to the 2^{nd} multiply and square circuit 305, and so forth, to the Nth multiply and square circuit 305. The low-pass filtered value Xbar need not be the absolute true mean for all frequencies, but can be used at least as a good approximation of the mean, particularly since a frequency of interest can be defined with the delay lines. As a result, serial data streams that would otherwise have a bandwidth that exceeds the capabilities of a conventional oscilloscope can be probed and verified to meet previously set standards for wave shape.

The 1^{st} through Nth multiply and square circuits 305 each calculate (X-Xbar)*(Y-Ybar) and output first analog signals 355. The delay lines (e.g., 310, 311, etc.) delay the input signal X for each multiply and square circuit as explained above, and therefore, each of the first analog signals 355 will vary one from another. Moreover, the 1^{st} through Nth multiply and square circuits 305 each calculate (X-Xbar)² and output second analog signals 360. Because the input signal X is delayed, each of the second analog signals 360 also varies one from another. Each of the 1^{st} through Nth multiply and square circuit 305 can include two multipliers, one to multiply the X and Y signals, and one to square the X signals. Because Y represents a previously stored reference signal, which is known and characterized for any particular standard, the calculation of the mean (i.e., Ybar) and/or standard deviation can be completed in advance of the multiply and square operations, and stored for later use.

Given enough die area to define a representative population of points on a waveform that can be used to uniquely identify the waveform of interest, a statistical correlation can be performed on the input signal 145 as it passes through the delay elements and lines in the logic 205. As described herein, X represents the signal under test 145 or the respective delayed signal under test, Xbar represents the mean of the signal under test, Y represents the reference signal as converted from a previously recorded digital format, and Ybar represents the mean of the reference signal Y. Since the input signal X is compared against a digital representation of a reference signal Y, which is subsequently converted to analog representations of the reference signal Y using DACs 315, the input signal 145 need not be digitized. This reduces jitter in an associated trigger event because no interpolation is needed. Any thresholds on discriminating a level of correlation can be hit in a fashion related in time to the input signal, not to any sampling clock, and therefore, this embodiments operates at sufficient speeds, whereas an analog to digital conversion of the input signal followed by calculation could otherwise be prohibitively slow. The ability to perform statistic correlation at 1GHz or more can be achieved with sufficiently fast IC processes. Thus, the input signal 145 can be compared in real-time to a previously stored digital representation of the signal defined by the DACs 315.

In other words, a "flow through" method of verification is performed using an implementation of the statistical correlation function, where the shape is set by defining a number of static levels (i.e., the Y-Ybar inputs and DACs 315), and then the output 150 can be watched to determine if there is ever a sufficient degree of correlation between the input signal 145 and the predefined shape described by the reference signal. Timing information is inherent in the delay liens and no data sampling in the conventional sense is required.

More specifically, the analog against digital logic 205 includes combination logic such as two analog summers 320 and 325. The summer 320 sums the first analog signals 355 and produces a covariance value 322. The covariance value 322 may be expressed as Covariance(X,Y). The summer 325 sums the second analog signals 360. An analog square root circuit 335 receives the output of the summer 325 and generates a square root value 337. The value 337 can be expressed as the standard deviation of X, or Stddev(X). The standard deviation value 337 can be derived using a fed-back multiplier.

An analog divider 330 divides the covariance value 322 by the standard deviation value 337 and produces a correlation value 150. The division by the standard deviation value normalizes the output. The division can also be performed using a fed-back multiplier. The multiply and square circuits 305, the delay lines (e.g., 310, 311, etc.), and the summers (e.g., 320, and 325) comprise an N-point analog covariance-correlation unit 350.

Accuracy can be changed by modifying the number of taps, or in other words, the number of DACs 315 and associated delay lines. In the case of six (6) taps, for example, the logic 205 can examine a single waveform transition so that aberrations and rise times can be compared with a set standard, or to otherwise qualify a waveform edge as being within a given specification or not. Other implementations can include far greater number of taps, on the order of 100s or more, allowing significantly more discrimination of the waveforms at a significantly finer resolution. Time spacing of the taps need not be uniform. In an oscilloscope, the inventive concepts described herein can be used at higher frequencies, or where fine resolution around special points is needed, whereas conventional digital correlation techniques may be used elsewhere where general shaping at a lower resolution and frequency are needed.

The comparison of the input signal represented by X to the predefined reference signal Y is such that the covariance value increases in amplitude when the analog input X more closely matches the predefined reference signal Y. The sign of the covariance value varies depending on whether the input signal is the same as or inverse to the predefined reference signal. In other words, the sign of the covariance value is positive when the input signal is the same as or closely corresponds to the predefined reference signal. Conversely, the sign of the covariance value is negative when the input signal deviates from or is inverse to the predefined reference signal. A positive covariance value signifies that the input signal is similarly sized as well as similarly shaped to the predefined reference signal. As such, covariance is a particularly useful value when both the input signal and the predefined reference signal are generally equal in amplitude.

In contrast to covariance, the correlation measurement removes the underlying scaling factor that is present in the covariance value. In other words, regardless of how big or how small the amplitudes or other differences between the input signal X and the predefined reference signal Y, the correlation value will always be quite large compared to the covariance value. This makes the correlation value more useful for cross-talk detection applications in which it is beneficial to detect even minute differences between two variables or signals.

The statistical correlation function automatically corrects for offset (i.e., by subtracting Xbar) and gain (i.e., by dividing by the standard deviation). In an alternative embodiment, if the automatic corrections are not desired, some simplification can be made. For example, the low pass filter 340 can be removed, thereby removing any concern about true mean. In addition, the generation of standard deviation and the associated division operation can be removed. This can remove all instances of fed-back multipliers and any need for squaring, thereby greatly enhancing speed and simplicity of the circuit. In such case, the covariance value becomes the output tested with a limit checker (not shown) to determine triggering on sufficiently high similarity between the input signal and the reference signal. Also, in such case, it may be desirable to limit check the offset and standard deviation functions as checks of amplitude and signal offset.

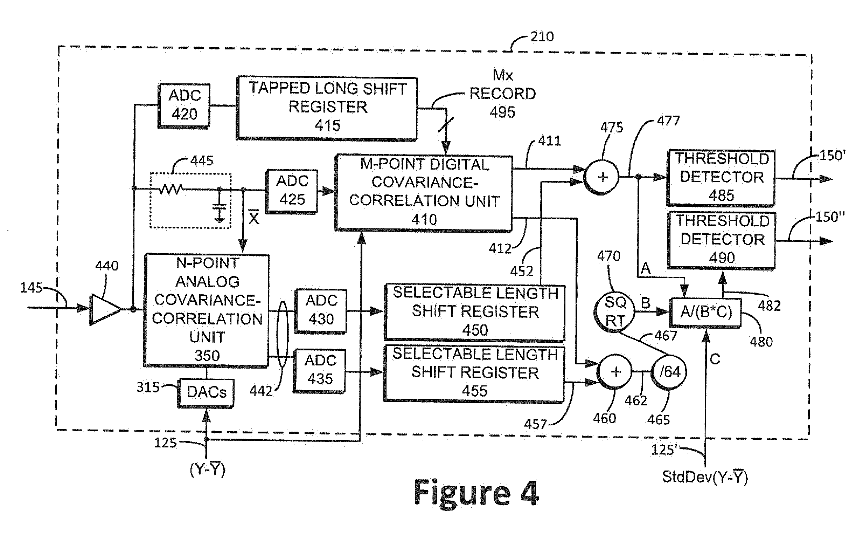

Figure 4 illustrates an example circuit diagram of the digital-analog hybrid logic 210 of the covariance-correlation logic 110 of Figure 2B. When finer resolution is needed, which can be made with digital shift registers, the N-point analog covariance-correlation unit 350 as previously described with reference to Figure 3 can be incorporated into a digital-analog hybrid approach.

The digital-analog hybrid logic 210 receives the analog input signal 145. The input signal 145 may be amplified by amplifier 440. An N-point analog covariance-correlation unit 350, such as the unit 350 shown in Figure 3, receives the input signal 145 and the digital to analog converted reference values 125 via DACs 315, and produces analog output values 442. The analog output values 442 can include, for example, the outputs of summers 320 and 325 of Figure 3. In other words, the covariance value and the squared value are brought out of the covariance-correlation unit 350 as analog signals, and are then digitized by ADCs 430 and 435, respectively.

The digitized reference values 125 can correspond to, for example, one or more portions of the prerecorded reference signal. In addition, the digitized reference values 125 can include predefined Y-Ybar information. The N-point analog covariance-correlation unit 350 receives the mean value Xbar, which is produced using the low pass filter circuit 445.

The ADC 420 receives and digitizes the input signal 145, and then outputs the digitized signal to a tapped long shift register 415, which delays the propagation of the digitized input signal 145. The tapped long shift register 415 outputs an Mx record 495. For example, if M is 56, then the tapped long shift register simultaneously outputs 56x input signal values. Preferably, N is less than M, but N can be any suitable value up to M depending on the desired speed and resolution. The sample rate depends on the speed at which the ADCs operate. For example, an oscilloscope clock may have a period of 100 picoseconds (ps). In such case, one point can be sampled for each 100 ps interval. It will be understood that any suitable sample or clock rate can be used.

An M-point digital covariance-correlation unit 410 receives the Mx record 495. The ADC 425 receives and digitizes the Xbar value, and transmits that value to the M-point digital covariance-correlation unit 410. The M-point digital covariance-correlation unit 410 can also receive the digitized reference values 125. The M-point digital covariance-correlation unit 410 produces two signals 411 and 412. The signal 411 includes covariance of a digitally produced portion of the input signal as delayed. The signal 412 includes a sum of digital squares.

More specifically, the M-point digital covariance-correlation unit 410 subtracts the digital mean value Xbar from the current digital value X, and creates the mathematical product of that result with the reference values for each tap. In other words, the M-point digital covariance-correlation unit 410 can digitally calculate (X-Xbar)*(Y-Ybar), and produce a sum of these based on the various taps, the sum of which is then output as signal 411. Put differently, the mathematical products are summed and are used to generate the combined covariance value 477 of the sampled values against the reference values. The reference values may be previously calculated and/or stored. In addition, the M-point digital covariance-correlation unit 410 can digitally calculate (X-Xbar)² for the various taps, and create a sum of such values, which is output as signal 412.

The outputs 411 and 412 are used to generate the covariance and correlation values digitally. The digital math circuit 480 generates the correlation value 482 based on the covariance value 'A', the standard deviation value 'B' (i.e., standard deviation of X-Xbar), and the standard deviation value 'C' (i.e., standard deviation of Y-Ybar). The digital threshold detector 485 can compare the covariance value 477 to a predefined threshold and cause a trigger event to occur if a threshold value is exceeded. Similarly, the digital threshold detector 490 can compare the correlation value 482 to a predefined threshold and cause a trigger event to occur if a threshold value is exceeded.

Selectable shift registers 450 and 455 receive the corresponding analog to digital converted output values 442, and produce signals 452 and 457, respectively, which are delayed based on the length of the corresponding shift register. The signal 452 includes covariance of the analogically produced portion as delayed by the shift register 450. The signal 457 includes a sum of analog squares as delayed by the shift register 455. After the appropriate delay times, a combined covariance value and a combined correlation can be generated, as explained in further detail below. The utility of the high speed or analogically produced portion of the analysis enabled by the analog components can be positioned within the incoming input signal or stream by varying the delay of the purely digital aspect against the analog aspect. In other words, the length of the shift register 450 and/or 455 can be adjusted depending on where in the signal pattern the high resolution analysis or triggering is desired.

The digital-analog hybrid logic 210 includes combination logic such as summers, dividers, square root circuits, and the like. The summer 475 receives and sums the signals 411 and 452, and outputs signal 477 or 'A', which is a combined covariance value of both the digitally produced and analogically produced portions. The summer 460 receives and sums the signals 412 and 457, and outputs signal 462, which is received by divider 465. The divider 465 divides the signal 462 by sixty four (64), and produces signal 467. A square root circuit 470 receives and calculates the square root of signal 467, and outputs signal 'B', which corresponds to the standard deviation of X-Xbar.

The digital math circuit 480 receives signals 'A' and 'B'. The math circuit 480 also receives signal 125' or 'C', which corresponds to the standard deviation of Y-Ybar. The standard deviation of Y-Ybar may be predefined or previously calculated, and previously stored in memory. The math circuit 480 calculates the mathematical result of A/(B*C), and produces a result 482, which corresponds to a combined correlation value of both the digitally produced and analogically produced portions. The resulting signal 482 is received by a threshold detector 490. If the threshold detector 490 detects whether the combined correlation value 482 exceeds a predefined threshold, then an action can be taken, such as triggering the oscilloscope 105 by transmitting signal 150". Moreover, a threshold detector 485 receives the combined covariance value 477, and detects whether it exceeds a predefined threshold, and if so, causes an action to be taken, such as triggering the oscilloscope 105 by transmitting signal 150'.

Unlike the embodiment shown in Figure 3, this embodiment is not limited to the time interval of the delay lines between the processing taps. Typically, the delay lines are not easily changed, and therefore, can lead to utility over a fairly narrow bandwidth. In this embodiment, however, higher bandwidth and higher resolutions are possible. Here, the trigger circuitry (of Figure 1) can trigger on a particular edge in definable data, such as a particular pulse stream. The analogically produced portion can allow finer determination of the trigger point in time since that portion of the result is inherently analog and continuous. As such, a particular shape can be drawn, either from an already acquired waveform or a theoretical waveform shape, and the input signal can be examined as time passes without needing to digitize it first. This allows for the identification of anomalies, which generally occur faster than the sampling rate might otherwise allow in a pure digital environment.

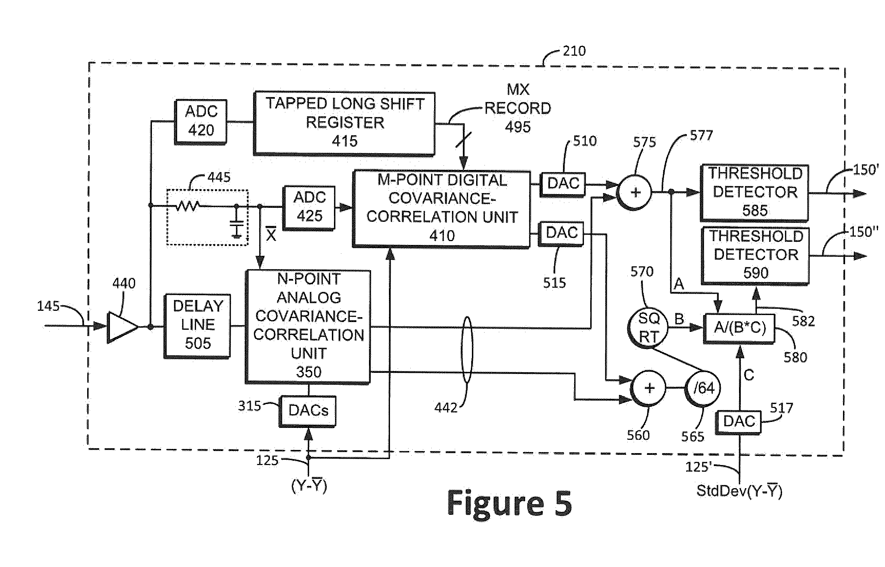

Figure 5 illustrates yet another example circuit diagram of the digital-analog hybrid logic 210 of the covariance-correlation logic 110 of Figure 2B. In this example embodiment, a long transmission or delay line 505 is disposed in front of the N-point analog covariance-correlation unit 350. The delay line 505 causes the high resolution portion (i.e., analogically produced portion) of the input signal 145 to be positioned somewhere in the middle or otherwise deeper into the data stream so that other waveform information can be seen before and after the high resolution portion. In other words, the delay line 505 can cause the covariance and correlation values to be associated with a position within the data stream other than a beginning and ending region of the input signal. Otherwise, it is difficult or impossible to know what is happening in the data stream before and after the interval of interest.

In addition, the digitally produced portion is converted back to analog using DACs 510 and 515, and the final operations are performed analogically. In other words, the summer 560 and 575, the square root circuit 570, the divider 565, the math circuit 580, and the threshold detectors 585 and 590, are all analog circuits in this example embodiment. The operations performed are similar to those described above with reference to the counterpart digital versions of these components shown in Figure 4, and therefore, a detailed description of their operation is not repeated for the sake of brevity. Two high speed ADCs (e.g., 420 and 425) are used for each channel. The ADC 420 measures the input signal 145 and the ADC 425 measures the mean, or low-pass filtered version, of the input signal as represented by Xbar. The tapped long shift register 415 is used for delaying the input signal.

The M-point digital covariance-correlation unit 410 subtracts the digital mean value Xbar from the current digital value X, and creates the mathematical product of that result with the reference values for each tap. In other words, the M-point digital covariance-correlation unit 410 can digitally calculate (X-Xbar)*(Y-Ybar), and produce a sum of these based on the various taps, the sum of which is then converted to an analog value using DAC 510. Put differently, the mathematical products are summed and are used to generate the combined covariance value 577 of the sampled values against the reference values. The reference values may be previously calculated and/or stored. In addition, the M-point digital covariance-correlation unit 410 can digitally calculate (X-Xbar)² for the various taps, and create a sum of such values, which is converted to an analog value using DAC 515.

The outputs of the DACs 510 and 515 are used to generate the covariance and correlation values analogically. The analog math circuit 580 generates the correlation value 582 based on the covariance value 'A', the standard deviation value 'B' (i.e., standard deviation of X-Xbar), and the standard deviation value 'C' (i.e., standard deviation of Y-Ybar). The threshold detector 585 can compare the covariance value 577 to a predefined threshold and cause a trigger event to occur if a threshold value is exceeded. Similarly, the threshold detector 590 can compare the correlation value 582 to a predefined threshold and cause a trigger event to occur if a threshold value is exceeded.

It should be noted that the selectable shift registers shown in Figure 4 are not needed in the embodiment shown here in Figure 5. That is because the N-point analog covariance-correlation unit 350 outputs analog signals 442, which are processed by the final analog components in the hybrid logic 210. This allows better time resolution of the trigger event than would otherwise be possible with a purely digital approach, because in this embodiment, the analog components examine the input waveform at a far faster rate than a digitization system could otherwise support. It should also be noted that the signal 125' is converted to an analog signal 'C' using DAC 517, so that the analog math circuit 580 can process the analog signals and produce an analog result. Given that the threshold detectors 585 and 590 are also analog components in this embodiment, the output signals 150' and 150" are also analog signals, which can cause one or more actions to occur, such as triggering the oscilloscope 105. By remaining in the analog domain, quantization errors can be reduced or eliminated. Alternatively, the output signals 150' and 150" can be converted to corresponding digital signals, which can be used by the trigger circuitry 160.

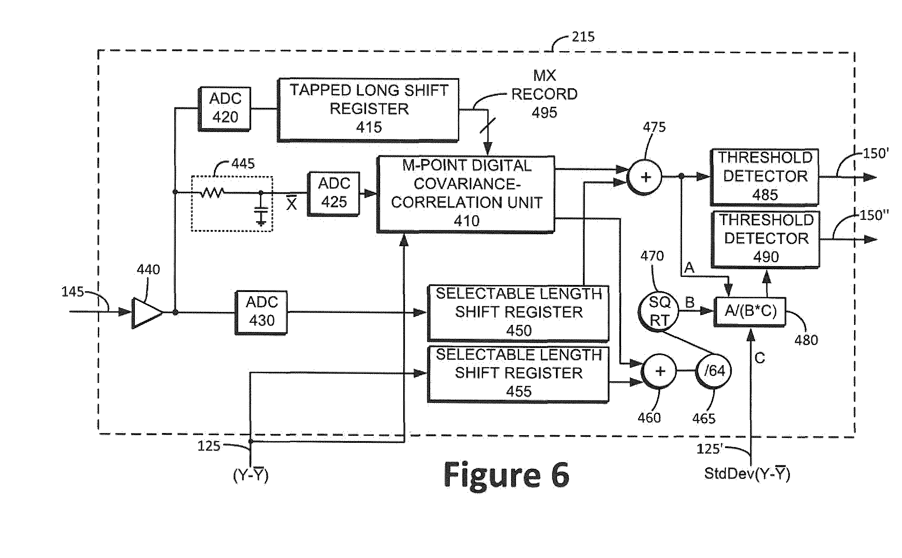

Figure 6 illustrates an example circuit diagram of the fully digital logic 215 of the covariance-correlation logic 110 of Figure 2C. Some of the elements of Figure 6 are similar to or the same as elements of Figure 4, and therefore, a detailed description of their operation is not repeated for the sake of brevity. It should be noted that in Figure 6, the analog components are removed. For example, the N-point analog covariance-correlation unit 350 and the DACs 315 are omitted.

Instead, in this embodiment, the circuit elements are digital. The input signal 145 is converted to a digital signal using ADCs 420 and 430. The mean value of the input signal Xbar is converted to a digital mean signal using ADC 425. The selectable length shift register 450 receives the input signal via ADC 430 and delays the input signal as desired. The selectable length shift register 455 receives the predefined reference signal 125 and delays it as needed. The remaining circuit elements operate in similar fashion as described with reference to Figure 4, and therefore, the description of these elements is not repeated.

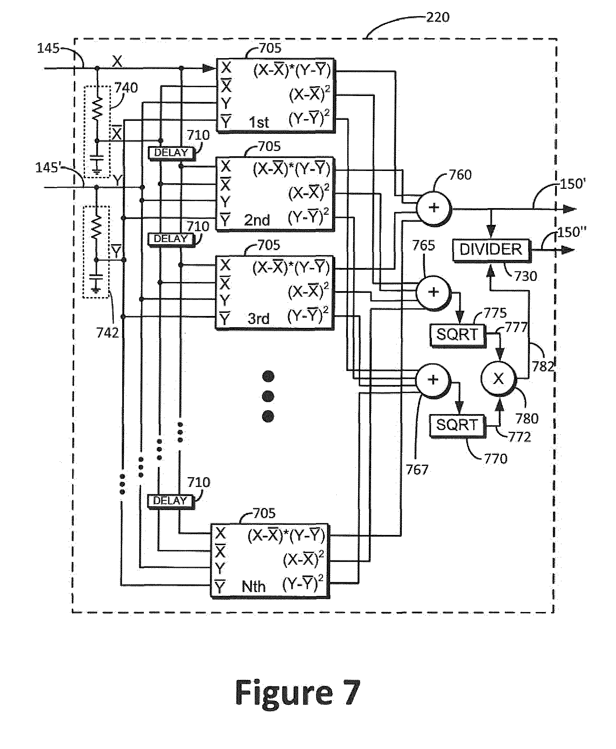

Figure 7 illustrates an example circuit diagram of the fully analog logic 220 of the covariance-correlation logic 110 of Figure 2D. This embodiment is particularly useful for triggering the oscilloscope 105 when two internal clocks are transitioning together because such a condition creates potential metastable conditions, and high speed analog detection can meet the necessary detection performance.

Instead of using DACs to convert previously stored Y-Ybar information, the analog logic 220 includes another input, which receives signal Y. Mean values Xbar and Ybar are produced using low pass filter circuits 740 and 742, respectively. The analog logic 220 includes 1^{st} through Nth analog multiply and square circuits 705, each of which receives the analog input signals X and Y, and the mean values Xbar and Ybar. Delay lines 710 are disposed between X inputs of the multiply and square circuits 705. Each multiply and square circuit 705 calculates (X-Xbar)*(Y-Ybar) and (X-Xbar)². In addition, each multiply and square circuit 705 calculates (Y-Ybar)² so that the correlation value can be calculated correctly.

The analog logic 220 includes combination logic for combining output values of the multiply and square circuits 705 to produce combined covariance and correlation values. For example, summer 760 sums the (X-Xbar)*(Y-Ybar) values from each of the 1^{st} through Nth multiply and square circuits 705, and produces a covariance value 150'. Summer 765 sums the (X-Xbar)² values from each of the 1^{st} through Nth multiply and square circuit 705, and produces a signal that is fed to a square root circuit 775. The square root circuit 775 produces signal 777, which is the standard deviation of X. Summer 767 sums the (Y-Ybar)² values from each of the 1^{st} through Nth multiply and square circuit 705, and produces a signal that is fed to a square root circuit 770. The square root circuit 770 produces signal 772, which is the standard deviation of Y. The square root circuits can be a special case of a divider circuit. The standard deviation signals 777 and 772 are fed to a multiplier circuit 780, which multiplies the two standard deviation signals together to produce combined signal 782. A divider circuit 730 divides the covariance value 150' by the combined signal 782 to produce a correlation value 150".

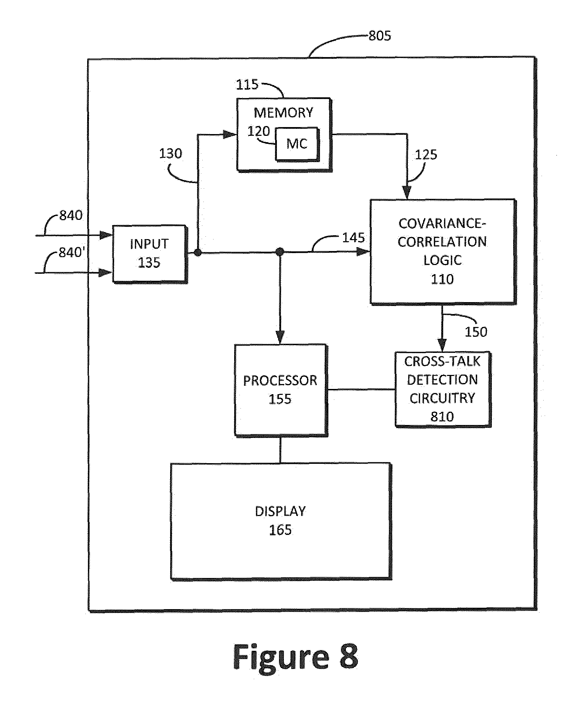

Figure 8 illustrates an example cross-talk detector instrument 805 including covariance-correlation logic 110 in accordance with embodiments of the present invention. The cross-talk detector instrument 805 can include similar components as the test and measurement instrument 105, but is designed specifically for detecting cross-talk between two lines carrying electrical signals. The detailed descriptions of the components that are the same or similar as those described above are not repeated for the sake of brevity.

The cross-talk detector instrument 805 includes two input signals 840 and 840'. One input signal 840 includes a high level signal causing the crosstalk, while another input signal 840' includes the signal being interfered with. It will be understood that the input signals are interchangeable. Instead of trigger circuitry, the cross-talk detector instrument 805 includes cross-talk detection circuitry 810. The cross-talk detection circuitry 810 receives threshold signals based on the covariance and correlation values generated by the covariance-correlation logic 110. The various embodiments of the covariance-correlation logic 110 can be included in the cross-talk detection instrument 805, and therefore, a detailed description is not repeated.

Although the foregoing discussion has focused on particular embodiments, other configurations are contemplated. The following discussion is intended to provide a brief, general description of a suitable machine or machines in which certain aspects of the inventive concept can be implemented. Typically, the machine or machines include a system bus to which is attached processors, memory, e.g., random access memory (RAM), read-only memory (ROM), or other state preserving medium, storage devices, a video interface, and input/output interface ports. The machine or machines can be controlled, at least in part, by input from conventional input devices, such as keyboards, mice, etc., as well as by directives received from another machine, interaction with a virtual reality (VR) environment, biometric feedback, or other input signal. As used herein, the term "machine" is intended to broadly encompass a single machine, a virtual machine, or a system of communicatively coupled machines, virtual machines, or devices operating together. Exemplary machines include computing devices such as personal computers, workstations, servers, portable computers, handheld devices, telephones, tablets, etc., as well as transportation devices, such as private or public transportation, e.g., automobiles, trains, cabs, etc.

The machine or machines can include embedded controllers, such as programmable or non-programmable logic devices or arrays, Application Specific Integrated Circuits (ASICs), embedded computers, smart cards, and the like. The machine or machines can utilize one or more connections to one or more remote machines, such as through a network interface, modem, or other communicative coupling. Machines can be interconnected by way of a physical and/or logical network, such as an intranet, the Internet, local area networks, wide area networks, etc. One skilled in the art will appreciated that network communication can utilize various wired and/or wireless short range or long range carriers and protocols, including radio frequency (RF), satellite, microwave, Institute of Electrical and Electronics Engineers (IEEE) 545.11, Bluetooth^{®}, optical, infrared, cable, laser, etc.

Embodiments of the inventive concept can be described by reference to or in conjunction with associated data including functions, procedures, data structures, application programs, etc. which when accessed by a machine results in the machine performing tasks or defining abstract data types or low-level hardware contexts. Associated data can be stored in, for example, the volatile and/or non-volatile memory, e.g., RAM, ROM, etc., or in other storage devices and their associated storage media, including hard-drives, floppy-disks, optical storage, tapes, flash memory, memory sticks, digital video disks, biological storage, etc. Associated data can be delivered over transmission environments, including the physical and/or logical network, in the form of packets, serial data, parallel data, propagated signals, etc., and can be used in a compressed or encrypted format. Associated data can be used in a distributed environment, and stored locally and/or remotely for machine access. Embodiments of the inventive concept may include a non-transitory machine-readable medium comprising instructions executable by one or more processors, the instructions comprising instructions to perform the elements of the inventive concept as described herein.

In one aspect, there is provided test and measurement instrument, comprising: a first circuit section configured to process an input signal under test and to produce N points of analogically produced covariance and correlation values; a second circuit section configured to process the input signal under test and to produce M points of digitally produced covariance and correlation values; and combination logic configured to combine the N points of analogically produced covariance and correlation values with the M points of digitally produced covariance and correlation values, respectively, into a combined covariance value and a combined correlation value. The test and measurement instrument may further comprise a threshold detector configured to detect when the combined covariance value or the combined correlation value exceeds a predefined threshold. The combination logic may comprise a summer configured to sum a digitally produced covariance value with an analogically produced covariance value. The combination logic may also comprise a summer to sum a digitally produced sum of squares with an analogically produced sum of squares, and to produce a combined sum; a divider circuit configured to divide the combined sum by a predefined value; a square root circuit configured to take a square root of the output of the divider, and to produce a standard deviation of X-Xbar, wherein X is associated with the input signal and Xbar is a mean value of X; and a math circuit configured to produce the combined correlation value based at least on the combined covariance value and the standard deviation of X-Xbar.

In another aspect, there is provided a test and measurement instrument, comprising: a first low pass filter circuit configured to generate a mean value Xbar of a first input signal X; a second low pass filter circuit configured to generate a mean value Ybar of a second input signal Y; and a plurality of analog multiply and square circuits configured to generate first signals based at least on the first input signal X, the mean value Xbar, the second input signal Y, and the mean value Ybar. The plurality of analog multiply and square circuits may be configured to generate second signals based at least on the first input signal X and the mean value Xbar. The plurality of analog multiply and square circuits may be configured to generate third signals based at least on the second input signal Y and the mean value Ybar. The test and measurement instrument may further comprise combination logic configured to combine at least two of the first signals, the second signals, and the third signals generated by the plurality of analog multiply and square circuits to produce an analog covariance value based at least on the first signals and/or to produce an analog correlation value based at least on the second signals and the third signals.

Other similar or non-similar modifications can be made without deviating from the intended scope of the inventive concept. Accordingly, the inventive concept is not limited except as by the appended claims.

## Claims

1. A method for correlating multiple signals, the method comprising:
receiving, by an input of a test and measurement instrument, a signal under test;
calculating a mean of the signal under test;
reading, from a memory, a digital reference signal;
converting the digital reference signal to an analog representation of the reference signal;
generating first signals based at least on the signal under test, the mean of the signal under test, and the reference signal;
generating second signals based at least on the signal under test and the mean of the signal under test;
producing a covariance value between the signal under test and the reference signal based at least on the first signals; and
producing a correlation value between the signal under test and the reference signal based at least on the first signals and the second signals.

2. The method of claim 1 or 2, wherein producing the covariance value includes summing the first signals.

3. The method of any preceding claim, wherein producing the correlation value includes:
summing the second signals;
calculating a square root of the summed second signals; and
dividing the covariance value by the square root of the summed second signals.

4. The method of any preceding claim, wherein receiving includes receiving the signal under test at a first multiply and square circuit.

5. The method of claim 4, further comprising:
delaying, by a first delay line, the signal under test; and
delaying, by a second delay line, the signal under test,
wherein receiving includes receiving the delayed signal that is delayed by the first delay line at a second multiply and square circuit and receiving the delayed signal that is delayed by the second delay line at a third multiply and square circuit.

6. The method of claim 5, wherein:
generating the first signals includes calculating, by each of the first through third multiply and square circuits, (X-Xbar) multiplied by (Y-Ybar); and
generating the second signals includes calculating, by each of the first through third multiply and square circuits, (X-Xbar)²,
wherein X represents the signal under test or respective delayed signal under test, Xbar represents the mean of the signal under test, Y represents the reference signal, and Ybar represents the mean of the reference signal.

7. The method of claim 5, wherein:
generating the first signals includes outputting, by each of the first through third multiply and square circuits, (X-Xbar) multiplied by (Y-Ybar); and
generating the second signals includes outputting, by each of the first through third multiply and square circuits, (X-Xbar)²,
wherein X represents the signal under test or respective delayed signal under test, Xbar represents the mean of the signal under test, Y represents the reference signal, and Ybar represents the mean of the reference signal.

8. A test and measurement instrument, comprising:
an input configured to receive a signal under test;
a low pass filter circuit configured to generate a mean of the signal under test;
a memory configured to store a digital reference signal;
a digital to analog converter configured to convert the digital reference signal to an analog representation of the reference signal;
a plurality of multiply and square circuits configured to generate first signals based at least on the signal under test, the mean of the signal under test, and the reference signal, and to generate second signals based at least on the signal under test and the mean of the signal under test;
first circuitry configured to produce a covariance value between the signal under test and the reference signal based at least on the first signals; and
second circuitry configured to produce a correlation value between the signal under test and the reference signal based at least on the first signals and the second signals.

9. The test and measurement instrument of claim 8, wherein the first circuitry further comprises:
a first summer configured to sum the first signals.

10. The test and measurement instrument of claim 8 or 9, wherein the second circuitry further comprises:
a second summer configured to sum the second signals;
a square root circuit configured to calculate a square root of the summed second signals; and
a divider circuit configured to divide the covariance value by the square root of the summed second signals.

11. The test and measurement instrument of any of claims 8 to 10, further comprising:
a first delay line configured to delay the signal under test; and
a second delay line configured to delay the signal under test,
wherein a first of the plurality of multiply and square circuits is configured to receive the input signal, a second of the plurality of multiply and square circuits is configured to receive the input signal delayed by the first delay line, and a third of the multiply and square circuits is configured to receive the input signal delayed by the first and second delay lines.

12. The test and measurement instrument of any of claims 8 to 11, wherein:
each of the plurality of multiply and square circuits is configured to generate and output (X-Xbar) multiplied by (Y-Ybar); and
each of the plurality of multiply and square circuits is configured to generate and output (X-Xbar)²,
wherein X represents the signal under test or respective delayed signal under test, Xbar represents the mean of the signal under test, Y represents the reference signal, and Ybar represents the mean of the reference signal.

13. A test and measurement instrument, comprising:
a first circuit section configured to process an input signal under test and to produce N points of analogically produced covariance and correlation values;
a second circuit section configured to process the input signal under test and to produce M points of digitally produced covariance and correlation values; and
combination logic configured to combine the N points of analogically produced covariance and correlation values with the M points of digitally produced covariance and correlation values, respectively, into a combined covariance value and a combined correlation value.

14. A test and measurement instrument, comprising:
a first low pass filter circuit configured to generate a mean value Xbar of a first input signal X;
a second low pass filter circuit configured to generate a mean value Ybar of a second input signal Y; and
a plurality of analog multiply and square circuits configured to generate first signals based at least on the first input signal X, the mean value Xbar, the second input signal Y, and the mean value Ybar.
